# EUROPEAN PATENT APPLICATION

(11) **EP 1 801 652 A2**
(43) Date of publication of application: **27.06.2007**
(21) Application number: 06125111.2
(22) Date of filing: 30.11.2006
(51) Int. Cl.: G03F 7/16, G03F 7/40, G03F 7/11

(54) **Methods of releasing photoresist film from substrate and bonding photoresist film with second substrate**

(30) Priority: 23.12.2005 KR 20050128745
(71) Applicant: Samsung Electronics Co., Ltd., Suwon-si, Gyeonggi-Do (KR)
(72) Inventor: Park, Chin-sung, c/o Samsung Electronics Co., Ltd., Suwon-si, Gyeonggi-do (KR); Hwang, Kyu-youn c/o Samsung Electronics Co., Ltd., Suwon-si, Gyeonggi-do (KR); Kim, Jin-tae, c/o Samsung Electronics Co., Ltd., Suwon-si, Gyeonggi-do (KR); Lee, Young-sun, c/o Samsung Electronics Co., Ltd., Suwon-si, Gyeonggi-do (KR)
(74) Representative: Grünecker, Kinkeldey, Stockmair & Schwanhäusser Anwaltssozietät

(57) **Abstract**

Provided is a method of releasing a photoresist film from a substrate, including: forming a self-assembled monolayer (SAM) on a substrate; coating the SAM with a photoresist film; and rinsing the substrate with an alcoholic group compound or an acid. A method of bonding a released photoresist film with a substrate includes arraying a second substrate and the photoresist film released from a first substrate using the above-described method, and baking the second substrate. According to the photoresist film releasing method, a photoresist film can be easily released from a substrate without damage after patterning. According to the bonding method, the photoresist film can be perfectly bonded with a second substrate without generating a crevice even though an additional adhesive is not used. When using the released photoresist film as an upper substrate of a microfluidic device, the manufacturing cost of the microfluidic device can be remarkably reduced compared to the manufacturing cost of existing microfluidic devices using a cover glass.

## Description

### BACKGROUND OF THE INVENTION

### 1. Field of the Invention

The present invention relates to a method of releasing a photoresist film from a substrate, and a method of bonding the photoresist film with a second substrate.

### 2. Description of the Related Art

A microfluidic device is a device including an inlet, an outlet, a reaction chamber, and a microchannel connecting the inlet, the outlet, and the reaction chamber. The microfluidic also includes a micropump for transferring fluids, a micromixer for mixing the fluids, a microfilter for filtering the fluids, etc., in addition to the microchannel.

Microfluidic devices are well known to those of ordinary skill in the art and are used in microanalysis devices such as Lab-on-a-chips (LOCs), which perform a series of biological analysis processes including cell enrichment, cell lysis, biomolecule refinement, nucleic acid amplification and separation, protein separation, hybridization reaction, and detection.

A microfluidic device can be formed using a silicon substrate and a glass substrate. To form a microfluidic device having an inlet, an outlet and a reaction chamber, a silicon lower substrate having a groove and a glass substrate having an inlet are disposed on one another, and the silicon substrate and the glass substrate are bonded using an anodic bonding method. However, such a method is expensive because sand blasting must be performed to form an inlet and an outlet. Therefore, a process in which a glass substrate is not used is required.

Another conventional method of manufacturing a microfluidic device requires the use of a photoresist such as SU-8. If a photoresist is directly coated on a lower silicon substrate in which a groove is formed, the groove can be clogged such that a reaction chamber cannot be formed. Therefore, a photoresist substrate and the lower silicon substrate in which the groove is formed should be bonded after separately manufacturing the photoresist on a separate substrate. However, the photoresist film, especially, when formed of SU-8, is not well released from a substrate because of the epoxy characteristics thereof.

A conventional method of separating a photoresist film from a substrate includes etching the substrate. In this method, the photoresist film is formed by coating a photoresist on the substrate, the photoresist is patterned by lithography, and the substrate is removed by dry etching or wet etching. However, the method is not economical and damage to the photoresist film often occurs during the etching process.

Another conventional method of separating a photoresist film from a substrate includes using an adhesive tape to attach the photoresist film to the substrate. In this method, an adhesive tape such as Kapton® is applied to the top of a substrate, the adhesive tape is coated with a photoresist to form a film, the photoresist is patterned by lithography, and the patterned photoresist film is released from the adhesive tape. However, this method is very likely to damage the photoresist film during a releasing process since the photoresist is very thin with a thickness of tens to hundreds of µm.

### SUMMARY OF THE INVENTION

The present invention provides a method of releasing a photoresist film from a substrate without damaging the photoresist film.

The present invention also provides a method of solidly bonding the photoresist film with a second substrate.

The present invention also provides a photoresist film which is formed by the releasing method.

The present invention also provides a photoresist film bonded with a second substrate by the bonding method.

According to an aspect of the present invention, there is provided a method of releasing a photoresist film from a substrate, including: forming a self-assembled monolayer (SAM) on the substrate; coating a photoresist film on the SAM; and rinsing the substrate with a alcoholic group compound or acid.

The substrate can be selected from the group consisting of silicon, glass, quartz, metals, and plastics.

The SAM can be formed of a compound including a silane group.

The material forming the SAM can be octadecyltrichlorosilane (ODC,) octadecyldimethyl (3-trimethoxysilylpropyl) ammonium chloride (OTC) or polyethyleneimine tri-methoxy-silane (PEIM.)

The forming of the SAM on the substrate may include dissolving an SAM-forming material in solution and soaking the substrate into the solution.

The photoresist may be a negative photoresist.

The photoresist may be SU-8.

The thickness of the photoresist may be in the range of 50 to 1,000 µm.

The coating of the photoresist film on the SAM may include spin-coating a photoresist liquid on the SAM and baking the substrate at 50 to 100°C.

The alcoholic group compound can be selected from the group consisting of isopropyl alcohol (IPA,) ethanol, propanol, and butanol.

The acid can be selected from the group consisting of a buffered oxide etchant (BOE) and a HF.

The method may further include patterning the photoresist film by lithography after the coating the photoresist on the SAM.

The patterning of the photoresist film may include can include an exposure process of irradiating 100-600 mJ/cm² of UV onto the photoresist film through a mask when the thickness of the photoresist is 50 to1,000 µm.

The patterning of the photoresist film can include a post-exposure baking (PEB) process of heating the photoresist film from 65°C to 95°C and cooling the photoresist film to room temperature.

According to another aspect of the present invention, there is provided a method of bonding a released photoresist film and a substrate, the method including: arraying a second substrate and a photoresist film released from a first substrate using a method comprising forming a SAM on the first substrate, coating the SAM with the photoresist film, exposing the substrate with UV, baking the first substrate and rinsing the substrate with an alcoholic group compound or an acid; and baking the second substrate.

A micro-structure can be formed in the second substrate.

The post-exposure baking may comprise first baking at 60 to 70°C for one to ten minutes, and second baking at 110 to 150°C for 0.5 to two hours.

According to another aspect of the present invention, there is provided a photoresist film formed by the releasing method described above and used as a substrate of a reaction chamber of a microfluidic device.

According to another aspect of the present invention, there is provided A photoresist film bonded with a second substrate that is obtained by the bonding method described above and used as a reaction chamber of a microfluidic device.

### BRIEF DESCRIPTION OF THE DRAWINGS

The above and other features and advantages of the present invention will become more apparent by describing in detail exemplary embodiments thereof with reference to the attached drawings in which:
FIGS. 1A through 1F are cross-sectional views illustrating a method of releasing a photoresist film from a first substrate and bonding the released photoresist film to a second substrate according to an embodiment of the present invention;
FIG. 2A is a photograph of an SU-8 film having a 500µm thickness in which a uniform pattern is formed that has been released from a substrate by a method according to an embodiment of the present invention;
FIG. 2B is a photograph of an SU-8 film having a 200µm thickness in which a uniform pattern is formed that has been released from a substrate by a method according to an embodiment of the present invention;
FIG. 2C is a photograph illustrating the SU-8 film of FIG. 2B bonded with a silicon wafer in which a uniform pattern is formed;
FIG. 2D is a photograph illustrating the silicon wafer of FIG. 2C that was diced;
FIG. 3A is a cross-sectional view conceptually illustrating that it is not possible to perform perfect bonding without crevices between a photoresist film and a second substrate when bonding a second substrate and a photoresist film without releasing the photoresist from a first substrate;
FIG. 3B is a cross-sectional view conceptually illustrating that it is possible to perform perfect bonding without crevices between a photoresist film and a second substrate in a method according to an embodiment of the present invention;
FIG. 4A is a photograph illustrating a silicon wafer and SU-8 which were bonded by a method according to an embodiment of the present invention; and
FIG. 4B is an enlarged photograph of a square part of FIG. 4A.

### DETAILED DESCRIPTION OF THE INVENTION

The present invention will now be described more fully with reference to the accompanying drawings, in which exemplary embodiments of the invention are shown. The invention may, however, be embodied in many different forms and should not be construed as being limited to the embodiments set forth herein; rather, these embodiments are provided so that this disclosure will be thorough and complete, and will fully convey the concept of the invention to those skilled in the art.

A method of releasing a photoresist film from a substrate according to an embodiment of the present invention includes forming a self-assembled monolayer (SAM) on the substrate; coating the SAM with a photoresist film; and rinsing the substrate with alcoholic group compounds or acids.

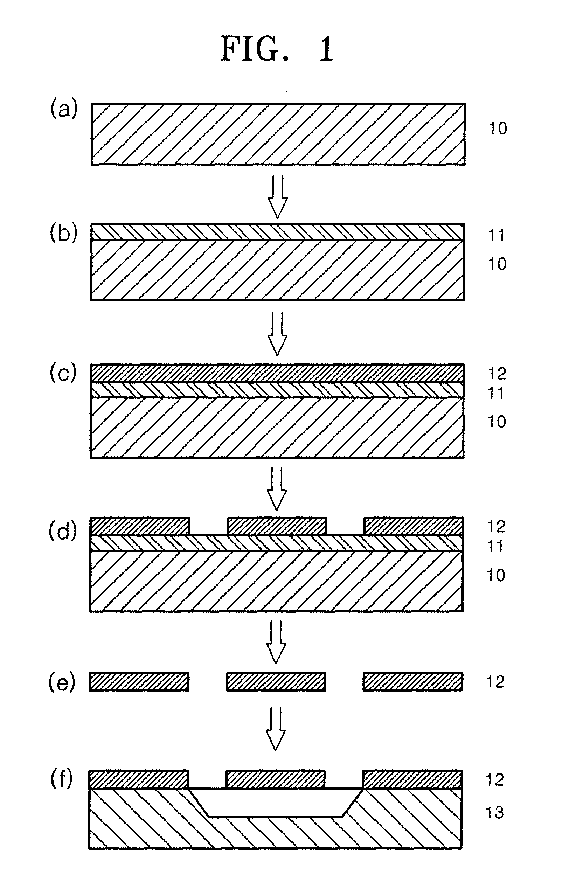

FIGS. 1A through 1F are cross-sectional views illustrating a method of releasing a photoresist film from a first substrate and bonding the released photoresist film to a second substrate according to an embodiment of the present invention.

Referring to FIGS. 1A and 1B, an SAM 11 is formed on a substrate 10.

The material forming the first substrate 10 is not particularly limited. For example, the first substrate 10 can be formed of silicon, glass, quartz, a metal, or a plastic.

The SAM formation is known in the art, and a material forming the SAM is not particularly limited. The SAM can be formed of a compound including a silane group. For example, the material can be octadecyltrichlorosilane (ODC,) octadecyldimethyl (3-trimethoxysilylpropyl) ammonium chloride (OTC,) or polyethyleneimine tri-methoxy-silane (PEIM).

In an embodiment of the present invention, after the SAM was formed using such a material as described above, a water micro-droplet was dropped on an SU-8 film and a contact angle between the first substrate surface and a tangent line of a part contacted by the water droplet was measured, and the relationship between the contact angle and releasing properties of the SU-8 film was checked. The contact angles of the materials are shown in Table 1.

The releasing properties of the SU-8 film were best when using ODC as a SAM-forming material, and second best when using OTC. PEIM had the least desirably results. Accordingly, it can be seen that a greater contact angle of the materials results in better releasing properties of the materials. This result is contrary to the following results: the direct coating SU-8 on a silicon substrate has larger contact angle but worse releasing properties, compared to the direct coating SU-8 on a SiO₂ substrate.

**<Table 1>**

| Substrate | SAM-forming material | Contact angle (° ) |
|---|---|---|
| Silicon | ODC | 110-115 |
| Silicon | OTC | 80-85 |
| Silicon | PEIM | 30-35 |

The operation of forming the SAM 11 on the first substrate 10 can include: dissolving a SAM-forming material in a solution; and soaking the first substrate 10 in the solution after the dissolving. The solution can be ethanol. When the first substrate 10 is soaked in the solution, the SAM 11 is formed on the surface of the first substrate 10.

Referring to FIG.1C, a photoresist film 12 is coated on the SAM 11.

The photoresist can be positive or negative. In an embodiment of the present invention, SU-8 may be used to form the photoresist film 12.

An SU-8 photoresist is a negative photoresist produced by Microchem, U.S., and is commonly referred to as a negative epoxy based near-UV photoresist. Since SU-8 is transparent when in the form of a layer and has excellent mechanical hardness, it is suitable as a substrate for a reaction chamber of a microfluidic device.

The thickness of the photoresist film 12 can be 50 to 1,000 µm. When the thickness of the photoresist 12 is less than 50 µm, the photoresist film 12 may not be sufficiently hard. When the thickness of the photoresist film 12 is greater than 1,000 µm, it is difficult to manufacture the structure.

The operation of forming the photoresist film 12 on the SAM 11 can include spin-coating a photoresist solution on the SAM 11; and baking the result at 50 to 100 °C.

Next, the photoresist 12 is patterned by lithography as illustrated in FIG. 1D. This operation is optional.

The process of patterning the photoresist film 12 can include an exposure process, a post-exposure baking (PEB) process, a development process, or a combination of these processes.

The exposure process includes irradiating 100-600 mJ/cm² UV light on the photoresist 12 film through a mask if the thickness of the photoresist is 50 to 1,000 µm.

When intensity of the UV light is less than 100 mJ/cm², the photoresist film 12 becomes weak. When the intensity of the UV light is greater than 600 mJ/cm², excessive cross-linking occurs in an SU-8 layer, and thus the photoresist film 12 will not properly bond with a second substrate 13 in a subsequent bonding process.

The PEB process includes a process of heating from 65°C to 95°C, and then cooling to room temperature. When the cooling process is omitted, a crack can result from differences in the thermal expansion coefficients of the first substrate 10 and the photoresist film 12.

The development process can be performed for 20 minutes by a method known in the art.

Next, referring to FIG. 1E, the first substrate 10, on which the SAM 11 and the photoresist film 12 are laminated, is rinsed with an alcohol-group compound or an acid.

In this operation, the photoresist film 12 is easily released from the SAM 11 and the substrate 10 without damage.

The rinsing process time is not limited, and can be from one to ten minutes, for example, one minute.

The rinsing process with the alcohol-group compound is generally used in a semiconductor process in which a photoresist, for example, SU-8, is involved. Therefore, the present invention has a strong point in that the photoresist film 12 can be released by a normal rinsing process known in the art.

The alcohol-group compound is not particularly limited. For example, the alcohol-group compound can be selected from the group consisting of isopropyl alcohol (IPA,) ethanol, propanol, and butanol. In an embodiment of the present invention, the alcohol-group compound can be IPA.

Moreover, if it is difficult to release the photoresist film 12 from the first substrate 10 using the alcoholic group compound, the photoresist film 12 can be released by additionally or alternatively using an acid.

The acid not particularly limited, and can be a buffered oxide etchant (BOE) or a HF, and is preferably BOE.

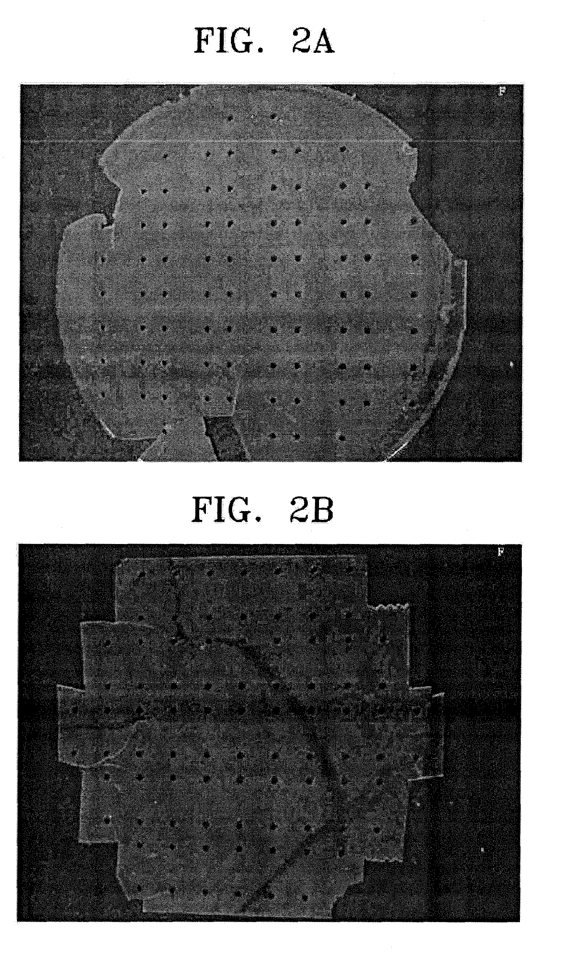

FIG. 2A is a photograph of an SU-8 film having a 500 µm thickness in which a uniform pattern is formed that has been released from a substrate by a method according to an embodiment of the present invention, and FIG. 2B is a photograph of an SU-8 film having a 200 µm thickness in which a uniform pattern is formed that has been released from a substrate by a method according to an embodiment of the present invention.

Referring to FIGS. 2A and 2B, since the SU-8 film is formed by coating a silicon wafer with SU-8, the SU-8 film released from the silicon wafer is circular.

If a chamber of a microfluidic device is to be formed through bonding with another substrate, a plurality of holes which can be an inlet and an outlet are formed in the SU-8 film.

The damaged trace of the edge area in FIGS. 2A and 2B is resulted from carelessness of an operator during storage, and thus is irrelevant to the method according to the present invention.

The present invention provides a method of bonding the released photoresist film with a second substrate, the method including: arraying a second substrate and a photoresist film released from a first substrate using a method comprising forming a SAM on the first substrate, coating the SAM with the photoresist film, and rinsing the substrate with an alcoholic group compound or an acid; and baking the second substrate.

Referring to FIG. 1F, a micro-structure can be formed on the second substrate 13.

The released photoresist film 12 can be arrayed on the second substrate 13 at room temperature.

The baking operation can include first baking at 60 to 70°C for one to ten minutes; and second baking at 110 to 150°C for 0.5 to two hours.

When the temperature of the first baking is below 60°C, an error can occur in the alignment of the second substrate 13. When the temperature of the first baking is higher than 70°C, an alignment error can cause a process failure because initial bonding is too strong to allow for adjustments. Moreover, when the first baking time is less than one minute, partial bonding can occur because heat is not transferred evenly to all areas. When the first baking time is more than 10 minutes, the method is made unnecessarily long.

Moreover, when the second baking temperature is less than 110°C, the method is made unnecessarily long. When the second baking temperature is higher than 150°C, a SU-8 layer, which is an organic layer, can be damaged. When the second baking time is less than 0.5 hours, imperfect bonding may occur because the bonding strength is weak. If the second baking time is more than two hours, a SU-8 layer, which is an organic layer, can be damaged.

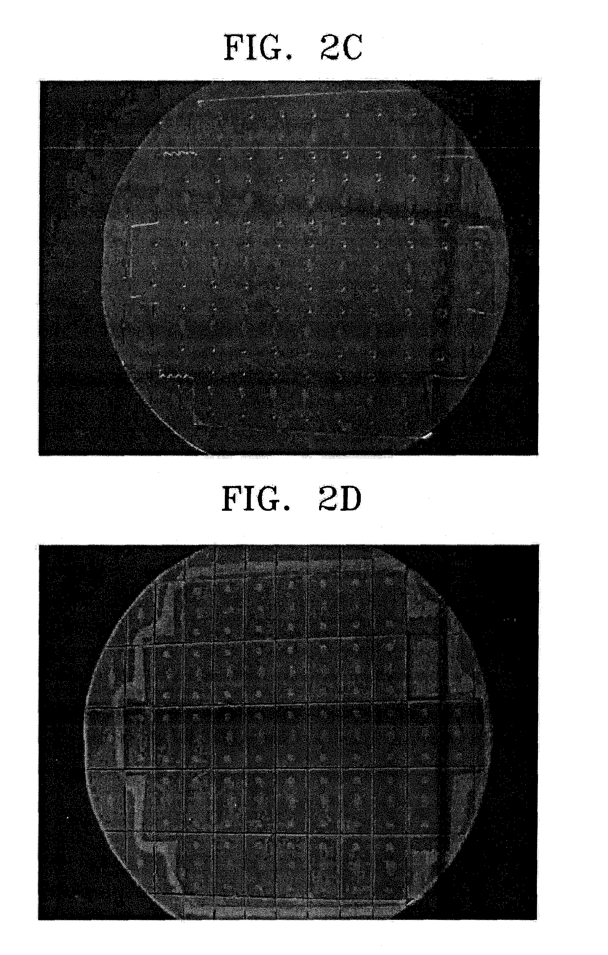

FIG. 2C is a photograph illustrating the SU-8 film of FIG. 2B bonded with a silicon wafer in which a uniform pattern is formed, and FIG. 2D is a photograph illustrating the silicon wafer of FIG. 2C which was diced.

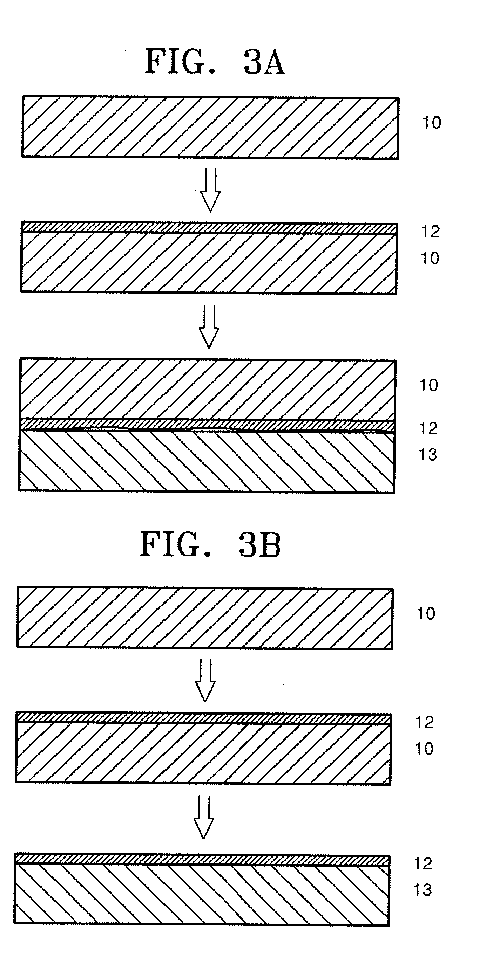

FIG. 3A is a cross-sectional view conceptually illustrating that it is not possible to perform perfect bonding without crevices between a photoresist film and a second substrate when bonding a second substrate and a photoresist film without releasing the photoresist from a first substrate. FIG. 3B is a cross-sectional view conceptually illustrating that it is possible to perform perfect bonding without crevices between a photoresist film and a second substrate in a method according to an embodiment of the present invention.

Referring to FIG. 3B, a side which was not in contact with the substrate 10 of the photoresist 12 is put in contact with the second substrate 13. Then, since the side put in contact with the second substrate 13 has up to 5% surface irregularity, the side cannot be bonded with the second substrate 13. Therefore, crevices between the side and the substrate are generated.

On the other hand, referring to FIG. 3A, in a method according to an embodiment of the present invention, a SAM layer and a photoresist film 12 are coated on a substrate 10, and then they are released. Next, the side of the photoresist film 12 which was in contact with the substrate 10 is bonded with a second substrate 13. Through this process, perfect bonding can be performed.

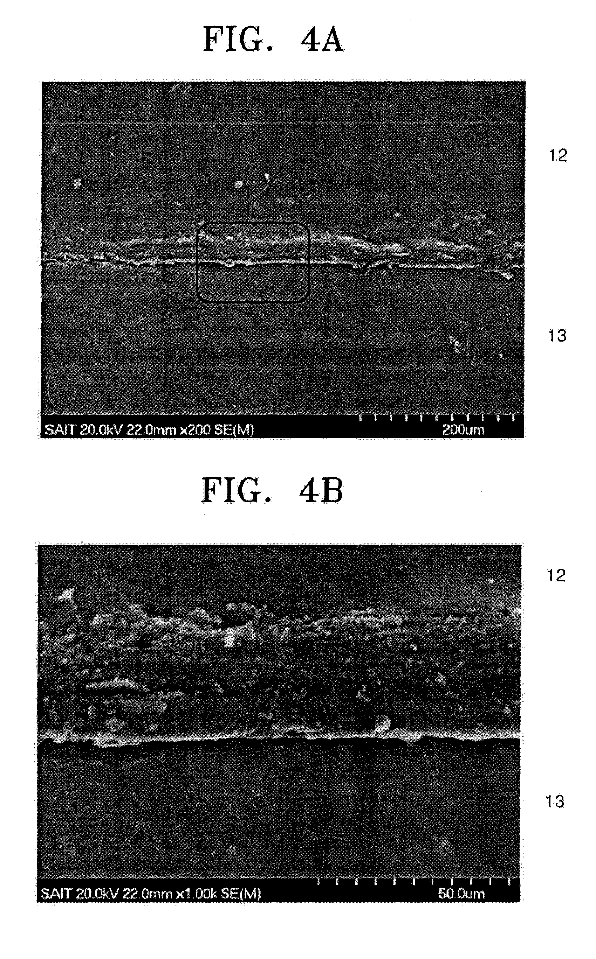

FIG. 4A is a photograph illustrating a silicon wafer 13 and SU-8 12 which were bonded by a method according to an embodiment of the present invention, and FIG. 4B is an enlarged photograph of a square part of FIG. 4A.

Referring to FIGS. 4A and 4B, it can be seen that the SU-8 12 and the silicon wafer 13 are solidly bonded. In the process of filming the picture, a part of the bonded side of the SU-8 12 was damaged because of carelessness, and not by the method according to an embodiment of the present invention.

A photoresist film according to an embodiment of the present invention is formed by the releasing method according to an embodiment of the present invention and is used as a substrate for a reaction chamber of a microfluidic device.

When used as a substrate of a reaction chamber of a microfluidic device, the photoresist can have an inlet and an outlet be used as a substitute for a cover glass. The inlet and the outlet are produced by sandblasting. The photoresist film can be 70% of more cheaper than a cover glass.

A second substrate and a bonded photoresist film according to an embodiment of the present invention is formed by the bonding method described above and is used as a reaction chamber of a microfluidic device.

When used as a reaction chamber of a microfluidic device, the photoresist can have an inlet and an outlet and be used as an upper substrate, and the second substrate can be used as a lower substrate and form a floor and walls.

The present invention will now be described in further detail with reference to the following examples. These examples are for illustrative purposes only, and are not intended to limit the scope of the present invention.

### <Example 1>

### Manufacture of reaction chamber

A SAM was formed on the surface of a first silicon wafer with a diameter of 4 inches by washing the first silicon wafer, dissolving ODC in ethanol, and dipping the first silicon wafer in the ODC-ethanol solution for 60 minutes. The contact angle, which was measured by dropping a water microdroplet on the substrate on which the SAM layer composed of ODC was formed, was 110-115°.

An SU-8 2100 from Microchem, U.S. was double spin-coated on the first silicon wafer at 1,000 rpm to a thickness of 500 µm using a spin coater device. Then, an SU-8 film was formed by heating the substrate coated with SU-8 2100 at 65°C for five minutes using a hot plate, increasing the temperature to 95°C at a rate of 1 °C/minute, and performing soft baking at 95°C for 15 minutes.

Next, UV light with an intensity of 480 mJ/cm² was radiated onto the SU-8 film by using a mask aligner through a mask in which a plurality of holes were formed.

In order to prevent bending of a silicon wafer by thermal stress, PEB after exposure was performed after heating the first silicon wafer to 65°C for one minute by using a hot plate, and increasing the temperature to 95°C at a rate of 5/3°C/minute, and cooling again to room temperature.

Next, the result was developed for 20 minutes and a structure having a regular pattern was formed on the SU-8 film.

The patterned SU-8 film was released from the substrate by rinsing IPA on the substrate for one minute.

A reaction chamber having an inlet and an outlet on top was manufactured by aligning the patterned SU-8 and the second substrate having a groove with a regular pattern at room temperature, heating the combination to 65°C for five minutes using a hot plate, and bonding by heating to 120°C for one hour.

### <Example 2>

### Manufacture of reaction chamber

A reaction chamber having an inlet and outlet on top was manufactured using the same method as in Example 1, except that the SU-8 2100 was coated to a thickness of 200 µm.

FIG. 2B is a photograph illustrating the SU-8 film released from a substrate in the present Example. FIG. 2C is a photograph illustrating the SU-8 film of FIG. 2B bonded with a silicon wafer which has a structure of a fixed pattern. FIG. 2D is a photograph illustrating the silicon wafer of FIG. 2C which was diced.

### <Example 3>

### Manufacture of reaction chamber

A reaction chamber having an inlet and outlet on top was manufactured using the same method as in Example 1, except that a SAM was formed using 3 - trimethoxysilylpropyl and OTC and that BOE rinsing was performed in addition to IPA rinsing.

A contact angle which was measured by dropping a water microdroplet onto the substrate on which the SAM layer composed of OTC was formed was 80 to 85° .

### <Example 4>

### Manufacture of reaction chamber

A reaction chamber having an inlet and outlet on top was manufactured using the same method as in Example 1, except that a SAM was formed using PEIM, and BOE rinsing was performed in addition to IPA rinsing.

A contact angle which was measured by dropping a water microdroplet onto the substrate on which the SAM layer composed of PEIM was formed was 30 to 35° .

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A method of releasing a photoresist from a substrate, comprising:
forming a self-assembled monolayer (SAM) on a substrate;
coating the SAM with a photoresist film; and
rinsing the substrate with an alcoholic group compound or an acid.

2. The method of claim 1, wherein the substrate is formed of a material selected from the group consisting of silicon, glass, quartz, a metal, and a plastic.

3. The method of claim 1, wherein the SAM is formed of a compound containing a silane group.

4. The method of claim 1, wherein the SAM is formed of octadecyltrichlorosilane (ODC), octadecyldimethyl (3-trimethoxysilylpropyl) ammonium chloride (OTC), or polyethyleneimine tri-methoxy-silane (PEIM).

5. The method of claim 1, wherein the forming of the SAM on the substrate comprises:
dissolving an SAM-forming material in a solution; and
soaking the substrate in the solution.

6. The method of claim 1, wherein the photoresist is a negative photoresist.

7. The method of claim 1, wherein the photoresist is formed of SU-8.

8. The method of claim 1, wherein the photoresist has a thickness of 50 to 1,000 µm.

9. The method of claim 1, wherein the coating the SAM with the photoresist film comprises:
spin-coating a photoresist solution on the SAM; and
baking the substrate at 50 to 100°C.

10. The method of claim 1, wherein the alcoholic group compound is selected from the group consisting of isopropyl alcohol, ethanol, propanol, and butanol.

11. The method of claim 1, wherein the acid is selected from the group consisting of a buffered oxide etchant and a HF.

12. The method of claim 1, further comprising patterning the photoresist film by lithography after coating the photoresist on the SAM.

13. The method of claim 12, wherein the photoresist is formed to a thickness of 50-1,000 µm and the patterning the photoresist film comprises radiating UV light with an intensity of 100-600 mJ/cm² on the photoresist film through a mask.

14. The method of claim 12, wherein the patterning the photoresist film comprises post-exposure baking (PEB) process including:
increasing the temperature to 65°C;
increasing the temperature to 95°C; and
cooling to room temperature.

15. A method of bonding a released photoresist film with a substrate, comprising:
arraying a second substrate and a photoresist film released from a first substrate using a method comprising forming a SAM on the first substrate, coating the SAM with the photoresist film, and rinsing the substrate with an alcoholic group compound or an acid; and
baking the second substrate.

16. The method of claim 15, wherein a micro-structure is formed in the second substrate.

17. The method of claim 15, wherein the post-exposure baking comprises:
first baking at 60 to 70°C for one to ten minutes; and
second baking at 110 to 150°C for 0.5 to two hours.

18. A photoresist film formed by the method of claim 1 and used as a substrate of a reaction chamber of a microfluidic device.

19. A photoresist film bonded with a second substrate that is obtained by the method of claim 15 and used as a reaction chamber of a microfluidic device.
